# EUROPÄISCHE PATENTSCHRIFT

(11) **EP 1 033 421 B1**
(45) Veröffentlichungstag und Bekanntmachung des Hinweises auf die Patenterteilung: **25.09.2002**
(21) Anmeldenummer: 99120980.0
(22) Anmeldetag: 04.11.1999
(51) Int. Cl.: C30B 15/20, F23G 7/06, B01D 53/64, B01D 51/10

(54) **Oxidationsvorrichtung und Verfahren zur Passivierung von Stäuben**
Oxidation apparatus and process for the passivation of dusts
Dispositif d'oxidation et procédé de passivation des poussières

(30) Priorität: 24.11.1998 DE 19854235
(43) Veröffentlichungstag der Anmeldung: 06.09.2000
(73) Patentinhaber: Wacker Siltronic Gesellschaft für Halbleitermaterialien Aktiengesellschaft, 84489 Burghausen (DE)
(72) Erfinder: Weber, Martin, Dr., 84556 Kastl (DE)
(74) Vertreter: Rimböck, Karl-Heinz, Dr.

(56) Entgegenhaltungen:
- EP-A- 0 347 753
- DE-A- 3 318 796
- DE-A- 4 208 151
- US-A- 3 914 088
- US-A- 4 959 085
- US-A- 5 800 792

## Beschreibung

Die Erfindung betrifft ein Verfahren zur Passivierung von brennbaren, metallurgischen Stäuben, die im Abgasfilter von Tiegelziehanlagen anfallen, insbesondere von Tiegelziehanlagen zum Ziehen von Siliciumeinkristallen. Die Erfindung betrifft auch eine Oxidationsvorrichtung zur Durchführung des Verfahrens.

Für die Herstellung hochreiner, einkristalliner Kristallstäbe wurde das Tiegelziehverfahren nach Czochralski bekannt. Beim Tiegelziehen von Kristallstäben, insbesondere von Siliciumstäben nach Czochralski, wird in der Regel der zur Erzeugung der Siliciumschmelze vorgesehene mono- oder polykristalline Siliciumbruch in einem Schmelztiegel, bevorzugt in einem Quarztiegel vorgelegt. Mittels einer Heizquelle wird der Siliciumbruch erhitzt und dann ein Impfkristall in die flüssige Schmelze getaucht und unter Drehung nach oben gezogen, wodurch ein Kristallstab am unteren Ende des Impfkristalls wächst.

Um den Leitfähigkeitstyp und den Widerstandswert des gezüchteten Kristalls festzulegen, werden dem Siliciumbruch bzw. der Schmelze Dotierstoffe, wie beispielsweise Bor, Phosphor, Arsen oder Antimon zugesetzt. Neben dem Siliciumbruch und den Dotierstoffen befindet sich noch Sauerstoff in der Schmelze. Der Sauerstoff, der der Schmelze von der Oberfläche des Quarztiegels durch den Kontakt zwischen beiden zugeführt wird, wird durch die zwangsweise Konvektion der Schmelze infolge der Rotation des Tiegels und der Wärmekonvektion der Schmelze aufgrund von Temperaturdifferenzen derselben in dem Tiegel bewegt.

Während dieser Bewegung wird der Sauerstoff z.T. von der Schmelzenoberfläche in Form der Oxide der Schmelzeninhaltsstoffe verdampft. Abhängig von dem jeweiligen Dotierstoff sind hier, neben SiO, insbesondere, aufgrund ihres hohen Dampfdrucks, die Sauerstoffverbindungen von Arsen und Antimon, insbesondere Arsen- und Antimontrioxid zu nennen. Da die Tiegelziehanlage in der Regel kontinuierlich von einem Schutzgas, bevorzugt von Argon, durchströmt wird, finden sich die Oxide der Schmelzeninhaltsstoffe in unterschiedlichen Oxidationsstufen in der Gasphase und im Abgasstrom der Anlage wieder.

Feinverteilte Metalloxid-/Halbmetalloxidgemische in mittleren Oxidationsstufen sind hochreaktive Industriestäube mit Selbstentzündungstemperaturen unter 100 °C, die insbesondere in den nachgeschalteten Abgasfiltern zu Filterbränden oder Staubexplosionen neigen.

Das Patent US 5,800,792 beschreibt eine Vorrichtung und ein Verfahren zur Oxidation von Abgasen aus einer Halbleiter-Produktionsanlage, wobei diese Abgase jedoch keine Stäube enthalten, sondern oxidierbare Gase wie Silan oder Phosphin. Die Aufgabe der Erfindung bestand daher darin, die Selbstentzündungstemperaturen von brennbaren, metallurgischen Stäuben, die im Abgasfilter von Tiegelziehanlagen anfallen, zu erhöhen.

Gelöst wird die Aufgabe durch ein Verfahren zur Passivierung von brennbaren, metallurgischen Stäuben, die im Abgasfilter von Tiegelziehanlagen anfallen, das dadurch gekennzeichnet ist, daß die Stäube im Abgasstrom der Tiegelziehanlage mittels eines Reaktionsgases bei Temperaturen von 50 bis 500 °C kontinuierlich passiviert werden.

Unter Passivierung im Sinne der Erfindung wird die gezielte Oxidation kleiner Staubmengen in der Gasphase verstanden; unter Reaktionsgas werden oxidierend wirkende Gase oder Gasgemische verstanden.

Gelöst wird die Aufgabe auch durch eine Oxidationsvorrichtung zur Passivierung von brennbaren, metallurgischen Stäuben, die im Abgasfilter von Tiegelziehanlagen anfallen, gekennzeichnet durch eine Reaktionskammer 4 mit einer Heizvorrichtung 5, zumindest einem Reaktionsgaseinlaß 6, einer Mischvorrichtung 7, die einen in die Reaktionskammer strömenden Abgasstrom mit dem Reaktionsgas vermengt, und einer Steuereinheit 3, die in Abhängigkeit der Ziehbedingungen die Temperatur in der Reaktionskammer und die Reaktionsgaszufuhr in die Reaktionskammer regelt.

Überraschenderweise zeigte sich, daß durch eine exakt dosierte Zugabe eines Reaktionsgases zu dem Abgasstrom einer Tiegelziehanlage bei einer Temperatur von 50 bis 500°C, bevorzugt von 100 bis 300°C, eine Passivierung der gasförmigen Stäube erreicht wird, ohne daß der Ziehprozeß beeinträchtigt wird.

Als Reaktionsgas werden bevorzugt Luft, Sauerstoff, Ozon oder Gemische dieser Gase verwendet, wobei Luft als Reaktionsgas besonders bevorzugt ist.

Die Gasführung innerhalb der Reaktionskammer gewährleistet, beispielsweise durch eine geeignet lange Verweilzeit, die Übertragung der in der Reaktionskammer herrschenden Temperatur auf das Gasgemisch, bestehend aus Reaktionsgas und Abgasstrom. Die Reaktionsgaszufuhr und die Temperatur in der Reaktionskammer werden über eine Steuereinheit geregelt. Mittels einer Mischvorrichtung wird der in die Reaktionskammer strömende Abgasstrom mit dem Reaktionsgas vermengt.

Die Reaktionsgaszufuhr, die Temperatur in der Reaktionskammer und gegebenenfalls der Einsatz eines Katalysators sind abhängig von der Beschaffenheit der Stäube, die sich je nach Tiegelziehprozeß in Morphologie und Zusammensetzung unterscheiden, und der Menge der Stäube, die mit eingesetzter Siliciumeinwaage, Prozeßdauer und Temperatur zunimmt.

Die kontinuierliche Passivierung nur kleiner, gasförmiger Staubmengen in der erfindungsgemäßen Oxidationsvorrichtung während des Ziehprozesses mit geringen Mengen an Reaktionsgas hat verschiedene Vorteile. Insbesondere gelingt damit eine homogene Passivierung der Stäube, d.h. es entstehen keine Partikel oder Cluster, die zu selbstzündenden Glimmbränden oder Verpuffungen führen. Die Passivierung jeweils nur kleiner Staubmengen hat den Vorteil, daß der Reaktionsgas-Partialdruck, im Gasraum der Tiegelziehanlage nur geringfügig steigt, und daß die für den Tiegelziehprozeß erforderlichen Vakuumbedingungen dadurch nicht beeinträchtigt werden.

### Versuche

Die Leistungsfähigkeit des Verfahrens und der erfindungsgemäßen Oxidationsvorrichtung zur Durchführung des Verfahrens wird durch die Versuche 2 und 3 deutlich:

| | T[°C] | Luft[l/h] | T_{sz}[°C] | T_{z}[°C] |
|---|---|---|---|---|
| Versuch 1 | ― | ― | 155 | 260 |
| Versuch 2 | 230 | 200 | 220 | 290 |
| Versuch 3 | 230 | 500 | 220 | 330 |

Bei den Versuchen wurde je ein Kristallstab in einer Tiegelziehanlage gemäß dem Stand der Technik gezogen. Es herrschten exakt gleiche Ziehbedingungen, wie beispielsweise der Schutzgasdurchfluß, die Schmelzentemperatur, die Siliciumeinwaage, die Dotierstoffart und die Dotierstoffmenge in der Tiegelziehanlage. In Versuch 2 und 3 war im Abgasstrom der Tiegelziehanlage die beanspruchte Oxidationsvorrichtung zwischen Tiegelziehanlage und Abgasfilter positioniert. Die Reaktionskammer der Oxidationsvorrichtung war mittels einer Heizvorrichtung auf eine Temperatur T[°C] von 230°C erwärmt. Der durch die Reaktionskammer strömende Abgasstrom wurde mittels einer Mischvorrichtung mit Luft, die etwa 21 Volumenprozent reinen Sauerstoff enthält, vermengt. In Versuch 2 wurde der Abgasstrom mit 200 1 Luft pro Stunde (Luft [l/h]) und in Versuch 3 mit 500 l Luft pro Stunde (Luft [l/h]) vermengt.

Nach dem Ziehen der Kristallstäbe wurden die im Abgasfilter angefallenen Stäube untersucht. Die Selbstentzündungstemperatur T_{SZ}[°C] der Stäube konnte von 155°C (Versuch 1) mittels der Oxidationsvorrichtung auf 220°C (Versuch 2 und 3) erhöht werden. Gleichzeitig stieg die Zündtemperatur T_{Z}[°C] der Stäube von 260°C in Versuch 1 auf 290°C in Versuch 2 bzw. auf 330°C in Versuch 3.

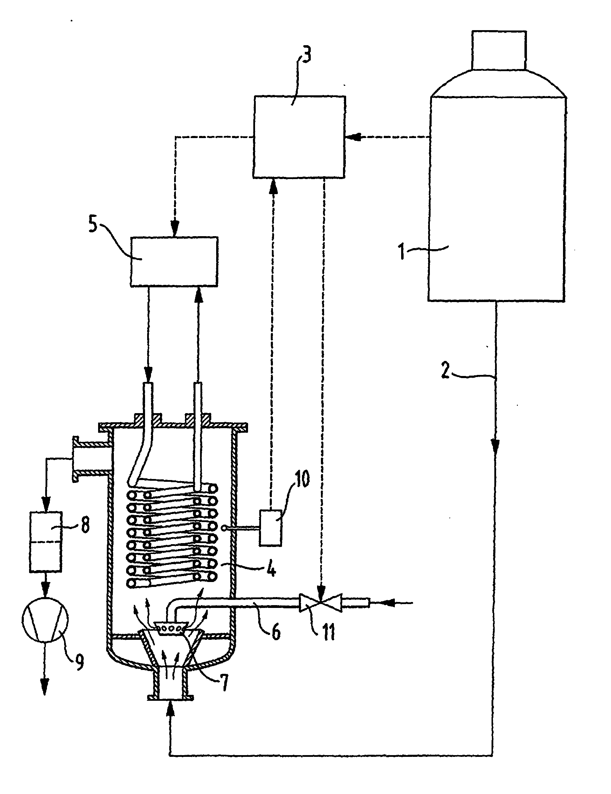

Anhand der Figur wird nachfolgend die Erfindung beschrieben.

Die Figur zeigt einen Vertikalschnitt durch eine bevorzugte Ausführungsform der erfindungsgemäßen Oxidationsvorrichtung, sowie schematisch durch eine Tiegelziehanlage, eine Steuereinheit, einen Abgasfilter und eine Vakuumpumpe. Die Figur zeigt auch die bevorzugte Anordnung der Oxidationseinheit im Abgasstrom einer Tiegelziehanlage.

Die Bezugsziffer 1 bezeichnet schematisch eine Tiegelziehanlage gemäß dem Stand der Technik mit einer Abgasableitung 2. Eine Steuereinheit 3 regelt die Temperatur in der Reaktionskammer (Sensor 10) und die Reaktionsgaszufuhr in die Reaktionskammer (Regelventil 11) der Oxidationsvorrichtung 4 in Abhängigkeit der Ziehbedingungen, wie beispielsweise des Schutzgasdurchflusses, der Schmelzentemperatur, der Siliciumeinwaage und der Dotierstoffart und der Dotierstoffmenge.

Die Reaktionskammer der Oxidationsvorrichtung 4 verfügt über eine Heizvorrichtung 5, die ein Gasgemisch, bestehend aus Reaktionsgas und Abgasstrom erwärmt, beispielsweise durch Wärmestrahlung, Konvektion oder Wärmeleitung.

Außerdem verfügt die Reaktionskammer 4 über zumindest einen Reaktionsgaseinlaß 6. Zur Vermengung des Abgasstroms mit dem Reaktionsgas ist zumindest eine Mischvorrichtung 7, beispielsweise in Form einer Düse oder einer gasführenden Fläche angebracht. Die Reaktionsgaszufuhr erfolgt beispielsweise über eine Lochblende oder eine durchflußkontrollierende Vorrichtung. Das Reaktionsgas, insbesondere Sauerstoff kann auch aus, beispielsweise zirkonoxidischen Materialien stammen, die sich in der Reaktionskammer 4 befinden. Die Reaktionsgeschwindigkeit kann durch eine heterogene Katalyse erhöht werden. Als Katalysatoren werden bevorzugt Edelmetalle verwendet, wobei Nickel, Palladium und Platin besonders bevorzugt sind.

Der Abgasstrom der Tiegelziehanlage strömt über eine Gaszuleitung in die Reaktionskammer der Oxidationsvorrichtung 4. Um eine Diffusion des Reaktionsgases oder des Gasgemisches, bestehend aus Reaktionsgas und Abgas von der Reaktionskammer 4 in Richtung der Tiegelziehanlage entgegen dem Abgasstrom zu verhindern, sind idealerweise geeignet geformte Blenden über der Gaszuleitung angebracht. Nach der Passivierung der brennbaren, metallurgischen Stäube wird der Abgasstrom über eine Gasableitung aus der Reaktionskammer 4 über einen Abgasfilter oder Staubfilter 8 zu einer Vakuumpumpe 9 geführt.

Die Erfindung reduziert die Brand- und Explosionsgefahr von brennbaren, metallurgischen Stäube und ermöglicht damit eine sichere Handhabung und Lagerung dieser Stäube.

## Patentansprüche

1. Verfahren zur Passivierung von brennbaren, metallurgischen Stäuben, die im Abgasfilter von Tiegelziehanlagen anfallen, **dadurch gekennzeichnet, daß** die Stäube im Abgasstrom der Tiegelziehanlage mittels eines Reaktionsgases bei Temperaturen von 50 bis 500 °C kontinuierlich passiviert werden.

2. Verfahren nach Anspruch 1, **dadurch gekennzeichnet, daß** die Reaktionsgaszufuhr und die Temperatur in der Reaktionskammer über eine Steuereinheit geregelt werden.

3. Verfahren nach Anspruch 1 oder 2, **dadurch gekennzeichnet, daß** mittels einer Mischvorrichtung der in die Reaktionskammer strömende Abgasstrom mit dem Reaktionsgas vermengt wird.

4. Oxidationsvorrichtung zur Passivierung von brennbaren, metallurgischen Stäuben, die im Abgasfilter von Tiegelziehanlagen anfallen, **gekennzeichnet durch** eine Reaktionskammer 4 mit einer Heizvorrichtung 5, zumindest einem Reaktionsgaseinlaß 6, einer Mischvorrichtung 7, die einen in die Reaktionskammer strömenden Abgasstrom mit dem Reaktionsgas vermengt, und einer Steuereinheit 3, die in Abhängigkeit der Ziehbedingungen die Temperatur in der Reaktionskammer und die Reaktionsgaszufuhr in die Reaktionskammer regelt.

## Claims

1. Method for passivating combustible, metallurgical dust which accumulates in the off-gas filter of crucible-pulling installations, **characterized in that** the dust in the off-gas flow from the crucible-pulling installation is passivated continuously by means of a reaction gas at temperatures of from 50 to 500°C.

2. Method according to Claim 1, **characterized in that** the reaction gas supply and the temperature in the reaction chamber are controlled by means of a control unit.

3. Method according to claim 1 or 2, **characterized in that** the off-gas flow which flows into the reaction chamber is mixed with the reaction gas by means of a mixing device.

4. Oxidation device for passivating combustible, metallurgical dust which accumulates in the off-gas filter of crucible-pulling installations, **characterized by** a reaction chamber 4 with a heater device 5, at least one reaction-gas inlet 6, a mixing device 7, which mixes on off-gas flow flowing into the reaction chamber with the reaction gas, and a control unit 3 which controls the temperature in the reaction chamber and the supply of reaction gas to the reaction chamber as a function of the pulling conditions.

## Revendications

1. Procédé de passivation de poussières métallurgiques combustibles, qui se forment dans le filtre de gaz de rejet d'installations de tirage en creuset, **caractérisé en ce que** les poussières dans le courant de gaz de rejet de l'installation de tirage en creuset sont passivées en mode continu à l'aide d'un gaz de réaction à des températures de 50 à 500°C.

2. Procédé selon la revendication 1, **caractérisé en ce que** l'alimentation du gaz de réaction et la température dans la chambre de réaction sont réglées par l'intermédiaire d'une unité de commande.

3. Procédé selon la revendication 1 ou 2, **caractérisé en ce que** l'on mélange le courant de gaz de rejet affluant dans la chambre de réaction au gaz de réaction à l'aide d'un dispositif de mélange.

4. Dispositif d'oxydation en vue de la passivation de poussières métallurgiques combustibles, qui se forment dans le filtre de gaz de rejet d'installations de tirage en creuset, **caractérisé par** une chambre de réaction 4, avec un dispositif de chauffage 5, avec tout au moins une admission de gaz de réaction 6, avec un dispositif de mélange 7, qui mélange un courant de gaz de rejet affluant dans la chambre de réaction avec le gaz de réaction, et avec une unité de commande 3, qui règle, en fonction des conditions de tirage, la température dans la chambre de réaction et l'alimentation du gaz de réaction dans la chambre de réaction.
